# EUROPÄISCHE PATENTSCHRIFT

(11) **EP 2 449 239 B1**
(45) Veröffentlichungstag und Bekanntmachung des Hinweises auf die Patenterteilung: **29.07.2015**
(21) Anmeldenummer: 10726081.2
(22) Anmeldetag: 22.06.2010
(51) Int. Cl.: F02D 41/20, H03K 17/0416, H03K 17/0814, B60T 8/36, H01F 7/18

(54) **ANSTEUERSCHALTUNG FÜR MEHRERE INDUKTIVE LASTEN UND VERFAHREN FÜR EINE ANSTEUERUNG VON INDUKTIVEN LASTEN**
DRIVER CIRCUIT FOR SEVERAL INDUCTIVE LOADS AND METHOD FOR DRIVING INDUCTIVE LOADS
CIRCUIT DE CONTROLE POUR PLUSIEURS CHARGES INDUCTIVES ET METHODE POUR CONTROLER LES CHARGES INDUCTIVES

(30) Priorität: 30.06.2009 DE 102009027340
(43) Veröffentlichungstag der Anmeldung: 09.05.2012
(73) Patentinhaber: ZF Friedrichshafen AG, 88038 Friedrichshafen (DE); KNORR-BREMSE Systeme für Nutzfahrzeuge GmbH, 80809 München (DE)
(72) Erfinder: VETTER, Manfred, 88048 Friedrichshafen (DE); GSCHEIDLE, Wolfgang, 71720 Oberstenfeld (DE); RIMPEL, Michael, 71701 Schwieberdingen (DE); DITTMAR, Christian, 70825 Korntal-Münchingen (DE)
(86) Internationale Anmeldenummer: PCT/EP2010/058755
(87) Internationale Veröffentlichungsnummer: WO 2011/000731

(56) Entgegenhaltungen:
- EP-A2- 1 260 694
- WO-A1-2008/071713
- DE-A1- 4 237 706
- DE-A1- 10 015 647
- DE-C1- 19 632 365
- US-A- 5 532 526
- US-A- 5 621 604

## Beschreibung

Die Erfindung betrifft eine Ansteuerschaltung für mehrere induktive Lasten und ein Verfahren für eine Ansteuerung von induktiven Lasten.

In z. B. Mechatronikanwendungen ist es erforderlich, induktive Lasten bzw. Aktuatoren pulsweitenmoduliert anzusteuern. Bei den anzusteuernden induktiven Lasten bzw. Aktuatoren kann es sich insbesondere um Magnetventile oder auch um Relais handeln.

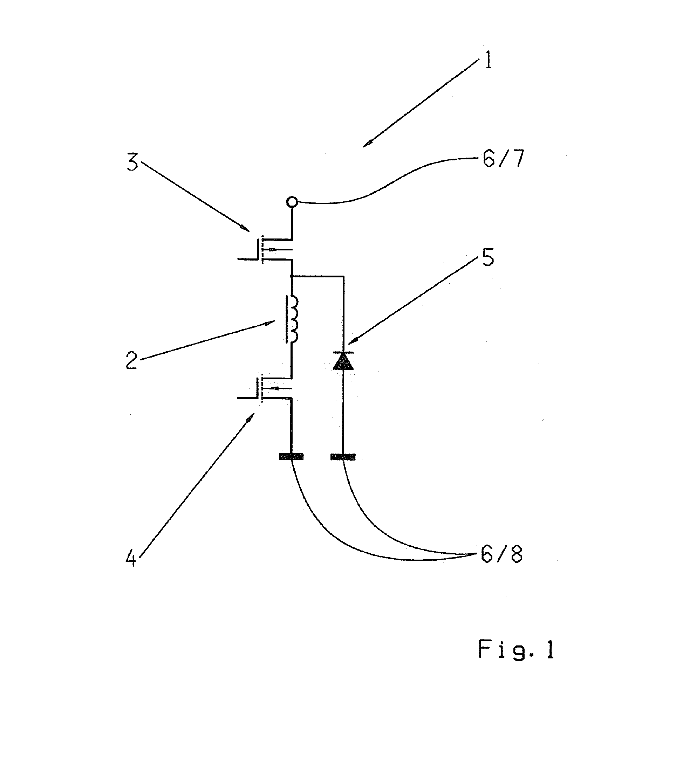

Fig. 1 zeigt eine aus dem Stand der Technik bekannte Ansteuerschaltung 1 für eine pulsweitenmodulierte Ansteuerung einer induktiven Last 2, wobei die Ansteuerschaltung 1 für die induktive Last 2 zwei Schalteinheiten 3 und 4 sowie eine Freilaufeinheit 5 umfasst. Die beiden Schalteinheiten 3 und 4 sind als Transistoren und die Freilaufeinheit 5 ist als Diode ausgebildet, wobei die induktive Last 2 zwischen die beiden als Transistoren ausgebildeten Schalteinheiten 3 und 4 und die als Diode ausgebildete Freilaufeinheit 5 parallel zur induktiven Last 2 und der Schalteinheit 4 geschaltet ist. Ein Drain-Anschluss der als Transistor ausgebildeten Schalteinheit 3 ist an ein erstes Potential 7 einer Spannungsversorgung 6 angeschlossen. Ein Source-Anschluss der ebenfalls als Transistor ausgebildeten Schalteinheit 4 ist an ein zweites Potential 8 der Spannungsversorgung 6 angeschlossen. Die induktive Last 2 ist zwischen den Source-Anschluss der Schalteinheit 3 und den Drain-Anschluss der Schalteinheit 4 geschaltet. Die als Diode ausgebildete Freilaufeinheit 5 greift mit der Kathode an den Source-Anschluss der Schalteinheit 3 und mit der Anode an das zweite Potential 8 der Spannungsversorgung 6 an. Gate-Anschlüsse der als Transistoren ausgebildeten Schalteinheiten 3 und 4 sind an eine nichtgezeigte Steuereinheit angeschlossen, mit Hilfe derer die Schalteinheiten 3 und 4 selektiv eingeschaltet und ausgeschaltet werden können.

Die Schalteinheit 3 steuert hierbei pulsweitenmoduliert die Last 2 an, wobei die Schalteinheit 4 rein statisch zugeschaltet ist. Dabei löscht die Freilaufeinheit 5 die induktive Energie aus der Last 2, wenn die Schalteinheit 3 abschaltet, wodurch an der Freilaufeinheit 5 eine dem Freilaufstrom proportionale Verlustleistung entsteht, die sehr hoch sein kann.

Mit Hilfe der in Fig. 1 gezeigten, aus dem Stand der Technik bekannten Ansteuerschaltung 1 für eine induktive Last 2 wird die induktive Last 2 somit pulsweitenmoduliert angesteuert, wobei Schaltvorgänge innerhalb kurzer Zeit ausgeführt werden können. Die Ansteuerschaltung 1 der Fig. 1 erfordert dabei für die Ansteuerung der induktiven Last 2 zwei Schalteinheiten 3 und 4 und eine Freilaufeinheit 6.

Dann, wenn eine Anzahl N induktiver Lasten unter Verwendung der in Fig. 1 gezeigten Ansteuerschaltung pulsweitenmoduliert angesteuert werden sollen, sind 2N Schalteinheiten sowie N Freilaufeinheiten und damit eine Vielzahl elektronischer Baugruppen erforderlich. Durch die hohe Anzahl der erforderlichen Baugruppen ergeben sich hohe Kosten sowie weiterhin ein hoher Bauraumbedarf. Dies ist von Nachteil.

Aus der DE 198 08 780 A1 ist eine Ansteuerschaltung für mehrere Verbraucher, bevorzugt elektromagnetische Ventile einer Brennkraftmaschine, bekannt mit einem ersten Schaltmittel (High-Side-Schalter), das zwischen einem gemeinsamen Anschluss der Verbraucher und einer Versorgungsspannungsquelle angeordnet ist und einem zweiten Schaltmittel (Ladeschalter), das zwischen dem Anschluss der Verbraucher und einer weiteren Spannungsquelle, die eine höhere Spannung als die Versorgungsspannungsquelle aufweist, angeordnet ist. Hierdurch kann der Verbraucher mit unterschiedlich hohen Spannungen beaufschlagt werden, um einen schnellen Schaltvorgang der Verbraucher zu realisieren. Die Ansteuerschaltung weist zudem eine in Serie zu dem ersten Schaltmittel und parallel zu den Verbrauchern geschaltete Freilaufdiode auf.

Aus der DE 100 15 647 A1 ist ein Verfahren und eine Vorrichtung zur Ansteuerung zumindest eines elektromagnetischen Verbrauchers, der aus einer Energieversorgungseinrichtung und einem elektrische Ladung speichernden Element versorgbar ist, bekannt. Bei Ansteuerung eines Booster-Schalters wird bewirkt, dass ein Strom von dem Ladung speichernden Element über den Booster-Schalter und den entsprechenden elektromagnetischen Verbraucher fließt.

Aus der DE 42 37 706 A1 ist eine Einrichtung zur Aufschlagszeitpunkt-Erkennung für Anker von Magnetventilen bekannt. Hierbei ist ein Freilaufkreis vorgesehen, der wenigstens eine Freilaufdiode aufweist und der den Magnetventilen parallel zugeschaltet ist und der jeweils für das gerade eingeschaltete Magnetventil wirksam ist.

Aus der EP 1 489 731 A1 ist ein Schaltkreis für mehrere induktive Lasten, insbesondere Elektroaktoren für Einspritzventile eines Verbrennungsmotors, bekannt, mit einem für alle induktiven Lasten gemeinsamen ersten elektronischen Schalter und mit einer Vielzahl von mit dem ersten elektronischen Schalter verbundenen Schaltungszweigen, welche jeweils eine der induktiven Lasten, eine Freilaufeinrichtung und einen zweiten elektronischen Schalter aufweisen. Die Freilaufeinrichtungen sind hierbei als dritte elektronische Schalter ausgeführt.

Hiervon ausgehend liegt der vorliegenden Erfindung das Problem zu Grunde, eine neuartige Ansteuerschaltung für mehrere induktive Lasten und ein Verfahren für eine Ansteuerung von induktiven Lasten zu schaffen, die bzw. das mit einer geringen Anzahl an Bauteilen und damit geringeren Kosten sowie einem geringeren Bauraumaufwand auskommt.

Dieses Problem wird durch eine Ansteuerschaltung gemäß Anspruch 1 und ein Verfahren gemäß Anspruch 13 gelöst.

Die erfindungsgemäße Ansteuerschaltung umfasst eine für alle induktiven Lasten gemeinsame Steuereinheit, eine für alle induktiven Lasten gemeinsame pulsweitenmodulierte Schalteinheit, eine für alle induktiven Lasten gemeinsame Freilaufeinheit, welche als eine pulsweitenmodulierte zweite Schalteinheit ausgebildet ist, eine für alle induktiven Lasten gemeinsame Spannungsversorgung und eine für jede induktive Last individuelle Endstufe, wobei die gemeinsame pulsweitenmodulierte Schalteinheit und die individuellen Endstufen derart mit der gemeinsamen Steuereinheit, der gemeinsamen Freilaufeinheit und der gemeinsamen Spannungsversorgung verschaltet sind, dass einerseits die gemeinsame pulsweitenmodulierte Schalteinheit und die gemeinsame Freilaufeinheit in Reihe geschaltet und andererseits die Endstufen zusammen mit den in Reihe zu den Endstufen geschalteten induktiven Lasten parallel zu der gemeinsamen Freilaufeinheit geschaltet sind, wobei die gemeinsame pulsweitenmodulierte Schalteinheit gesteuert durch die gemeinsame Steuereinheit die induktiven Lasten über die gemeinsame Spannungsversorgung zentral und pulsweitenmoduliert mit Spannung versorgt und die gemeinsame Freilaufeinheit durch die gemeinsame Steuereinheit im Betrieb der Ansteuerschaltung stets gegenphasig zu der gemeinsamen pulsweitenmodulierten Schalteinheit angesteuert ist, und wobei die Endstufen gesteuert durch die gemeinsame Steuereinheit jede der induktiven Lasten entweder individuell zuschaltet oder abschaltet.

Die erfindungsgemäße Ansteuerschaltung für mehrere induktive Lasten kommt gegenüber dem Stand der Technik mit einer geringeren Anzahl elektronischer Bauteile aus. Hierdurch kann der Bauraumaufwand reduziert werden. Weiterhin verringern sich die Kosten für die Ansteuerschaltung.

Die gemeinsame pulsweitenmodulierte Schalteinheit und/oder die gemeinsame Freilaufeinheit können bevorzugt als Halbleiterschalter oder Halbleiterschalter mit integrierter Diode ausgeführt sein, um Schaltverluste der Ansteuerschaltung zu minimieren.

Das erfindungsgemäße Verfahren sieht vor, dass die gemeinsame Schalteinheit und die gemeinsame Freilaufeinheit gegenphasig zur Erzeugung einer definierten Speisespannung der induktiven Lasten pulsweitenmoduliert durch die gemeinsame Steuereinheit angesteuert werden und dass die individuellen Endstufen angesteuert durch die gemeinsame Steuereinheit die induktiven Lasten individuell zuschaltet oder abschaltet, unabhängig von einem Schaltzustand der gemeinsamen Schalteinheit oder der gemeinsamen Freilaufeinheit.

Die vorstehend beschriebene Ansteuerschaltung eignet sich besonders für eine Verwendung in einem Getriebe zur Ansteuerung von elektromechanisch (elektromotorisch, elektromagnetisch, etc.) betätigten Schaltelementen (Kupplungen, Bremsen, etc.) des Getriebes, da sie mit besonders wenigen Bauteilen auskommt und eine geringe Verlustleistung aufweist. Die elektromechanisch betätigten Schaltelemente oder deren Ansteuerungsorgane (elektromagnetische Ventile, elektromotorische Aktoren etc.) bilden hierbei die genannten induktiven Lasten der Ansteuerschaltung. Hierdurch ist die Ansteuerschaltung auch in sehr beengten Bereichen des Getriebes einsetzbar. Bevorzugt wird die Ansteuerschaltung in einem elektronischen Steuergerät eines automatisierten oder automatischen Personen- oder Nutzfahrzeuggetriebes zur Ansteuerung von elektromechanischen Hydraulik- oder Pneumatikventilen (induktive Lasten) für die Ansteuerung von Schaltelementen des Personen- oder Nutzfahrzeuggetriebes eingesetzt, da besonders hier geringer Bauraumbedarf und eine geringe Verlustleistung von Vorteil sind.

Bevorzugte Weiterbildungen der Erfindung ergeben sich aus den Unteransprüchen und der nachfolgenden Beschreibung. Ein Ausführungsbeispiel der Erfindung wird, ohne hierauf beschränkt zu sein, an Hand der Zeichnung näher erläutert. Dabei zeigt:
- Fig. 1: eine aus dem Stand der Technik bekannte Ansteuerschaltung für eine induktive Last; und
- Fig. 2:: eine erfindungsgemäße Ansteuerschaltung für mehrere induktive Lasten;
- Fig. 3:: eine individuelle Endstufe mit einer integrierten Überspannungsschutzeinrichtung;
- Fig. 4a bis 4e:: zeitliche Verläufe von Schaltstellungen einer gemeinsamen pulsweitenmodulierten Schalteinheit und individueller Endstufen der Ansteuerschaltung nach Fig. 2, sowie eines Stroms und einer Spannung an einer der individuellen Endstufen.

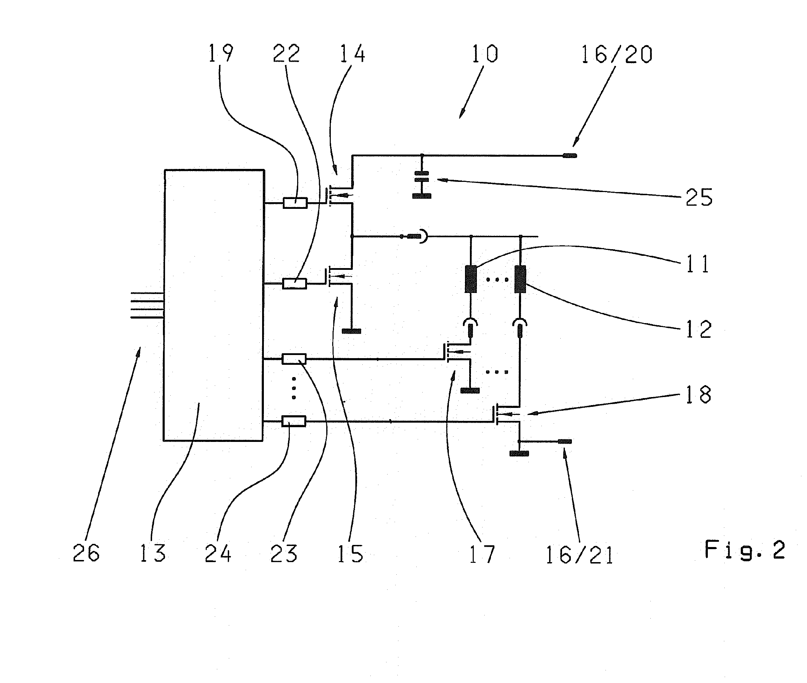

Fig. 2 zeigt eine erfindungsgemäße Ansteuerschaltung 10 zur pulsweitenmodulierten Ansteuerung mehrerer induktiver Lasten 11, 12 wobei in Fig. 2 lediglich zwei induktive Lasten 11, 12 gezeigt sind. Wie durch die Punkte zwischen den beiden induktiven Lasten 11 und 12 angedeutet, ist jedoch die Anzahl der mit Hilfe der erfindungsgemäßen Ansteuerschaltung 10 ansteuerbaren induktiven Lasten 11, 12 beliebig erweiterbar.

Die Ansteuerschaltung 10 der Fig. 2 umfasst eine für alle induktiven Lasten 11, 12 gemeinsame Steuereinheit 13, eine für alle induktiven Lasten 11, 12 gemeinsame pulsweitenmodulierte Schalteinheit 14, eine für alle induktiven Lasten gemeinsame Freilaufeinheit 15, eine für alle induktiven Lasten gemeinsame Spannungsversorgung 16 sowie für alle induktiven Lasten 11, 12 individuelle Endstufen 17, 18. Die gemeinsame Freilaufeinheit 15 ist hierbei als eine zweite Schalteinheit ausgebildet.

Die für alle induktiven Lasten 11, 12 gemeinsame pulsweitenmodulierte Schalteinheit 14 sowie die für alle induktiven Lasten 11, 12 gemeinsame Freilaufeinheit 15 sind gemäß Fig. 2 in Reihe geschaltet. Ebenso ist jede induktive Last 11, 12 in Reihe mit der jeweiligen individuellen Endstufe 17, 18 geschaltet, wobei gemäß Fig. 2 jede induktive Last 11, 12 zusammen mit der jeweiligen in Reihe geschalteten individuellen Endstufe 17, 18 zu der für alle induktiven Lasten 11, 12 gemeinsamen Freilaufeinheit 15 parallel geschaltet ist.

Die gemeinsame pulsweitenmodulierte Schalteinheit 14 ist durch die Steuereinheit 13 gesteuert und versorgt die induktiven Lasten 11, 12 über die gemeinsame Spannungsversorgung 16 zentral und pulsweitenmoduliert mit einer definierten Speisespannung. Ebenso sind die individuellen Endstufen 17, 18 von der gemeinsamen Steuereinheit 13 gesteuert, wobei über die Endstufen 17, 18 die induktiven Lasten 11, 12 individuell zugeschaltet oder abgeschaltet werden können. In der in Fig. 2 gezeigten, bevorzugten Ausführungsform der erfindungsgemäßen Ansteuerschaltung 10 ist die gemeinsame pulsweitenmodulierte Schalteinheit 14 als Transistor ausgebildet, insbesondere als Feldeffekt-Transistor. Ebenso ist die gemeinsame Freilaufeinheit 15 als Transistor, insbesondere als Feldeffekt-Transistor mit parasitärer integrierter Diode ausgebildet. Darüber hinaus sind die individuellen Endstufen 17, 18 der induktiven Lasten 11, 12 als Transistoren, insbesondere als FeldeffektTransistoren mit integrierter Überspannungsschutzeinrichtung, ausgeführt.

Alternativ können die Endstufen 17, 18 auch als Bipolar-Transistoren mit externer Überspannungsschutzeinrichtung ausgeführt sein. An dieser Stelle sei darauf hingewiesen, dass die pulsweitenmodulierte Schalteinheit 14 und die gemeinsame Freilaufeinheit 15 auch als Bipolar-Transistor ausgeführt sein können. Die gemeinsame Freilaufeinheit 15 verfügt dann bevorzugt über eine externe Diode.

Gemäß Fig. 2 ist die als Feldeffekt-Transistor ausgebildete, pulsweitenmodulierte gemeinsame Schalteinheit 14 über einen Gate-Anschluss an die gemeinsame Steuereinheit 13 angeschlossen, wobei zwischen den Gate-Anschluss der Schalteinheit 14 und die Steuereinheit 13 ein Widerstand 19 geschaltet ist. Über einen Drain-Anschluss ist die als Feldeffekt-Transistor ausgebildete Schalteinheit 14 an ein erstes Potential 20 der Spannungsversorgung 16 angeschlossen. Der Source-Anschluss der als Feldeffekt-Transistor ausgebildeten, für alle induktiven Lasten 11, 12 gemeinsamen Schalteinheit 14 ist hingegen an die für alle induktiven Lasten 11, 12 gemeinsame Freilaufeinheit 15 angeschlossen, die ihrerseits an einem zweiten Potential 21 der gemeinsamen Spannungsversorgung 16 anliegt.

Im bevorzugten Ausführungsbeispiel, in welcher die für alle induktiven Lasten 11, 12 gemeinsame Freilaufeinheit 15 ebenfalls als Feldeffekt-Transistor ausgeführt ist, greift der Source-Anschluss der als Feldeffekt-Transistor ausgebildeten Schalteinheit 14 am Drain-Anschluss der als Feldeffekt-Transistor ausgebildeten Freilaufeinheit 15 an. In diesem Fall liegt dann der Source-Anschluss der als Feldeffekt-Transistor ausgebildeten Freilaufeinheit 15 am zweiten Potential 21 der Spannungsversorgung 16 an. Über den Gate-Anschluss ist die Freilaufeinheit 15 an der Steuereinheit 13 angeschlossen, wobei zwischen die Steuereinheit 13 und den Gate-Anschluss der als Feldeffekt-Transistor ausgebildete Freilaufeinheit 15 ein Widerstand 22 geschaltet ist.

In dem Fall, in welchem die gemeinsame Freilaufeinheit 15 als Transistor mit (integrierter) parasitärer Diode ausgeführt ist, ist die Kathode dieser Diode der Freilaufeinheit 15 mit dem Source-Anschluss der Steuereinheit 14 verbunden. In diesem Fall ist dann die Anode der Diode der Freilaufeinheit 15 mit dem zweiten Potential 21 der Spannungsversorgung 16 verbunden.

Wie bereits ausgeführt, sind die induktiven Lasten 11, 12 zusammen mit den in Reihe zu den induktiven Lasten 11, 12 geschalteten Endstufen 17, 18 parallel zur Freilaufeinheit 15 geschaltet, wobei gemäß Fig. 2 Gate-Anschlüsse der als Feldeffekt-Transistoren ausgebildeten Endstufen 17, 18 unter Zwischenschaltung von Widerständen 23, 24 an die Steuereinheit 13 angeschlossen sind. Source-Anschlüsse der Endstufen 17,18 sind an das zweite Potential 21 der Spannungsversorgung 16 angeschlossen. Die induktiven Lasten 11, 12 greifen an den Drain-Anschlüssen der Endstufen 17, 18 an.

Wie bereits ausgeführt, sind sowohl die gemeinsame Schalteinheit 14 als auch die gemeinsame Freilaufeinheit 15 vorzugsweise über FeldeffektTransistoren realisiert. Bei diesen Transistoren kann es sich entweder um Einzeltransistoren oder um Transistoren eines Halbbrückentreibers handeln.

Im bevorzugten Ausführungsbeispiel der Fig. 2 greift am ersten Potential 20 der Spannungsversorgung 16 weiterhin eine Kapazität 25 an, die ebenfalls an das zweite Potential 21 der Spannungsversorgung 16 angeschlossen und damit parallel zu den beiden Transistoren der Schalteinheit 14 und der Freilaufeinheit 15 geschaltet ist.

Mit Hilfe der Steuereinheit 13 wird entweder die Schalteinheit 14 oder die Freilaufeinheit 15 gegenphasig zueinander eingeschaltet bzw. ausgeschaltet. Dann, wenn die Schalteinheit 14 eingeschaltet ist, ist die Freilaufeinheit 15 ausgeschaltet. Ist hingegen die Schalteinheit 14 ausgeschaltet, so ist die Freilaufeinheit 15 eingeschaltet. Die Schalteinheit 14 und die Freilaufeinheit 15 erzeugen dabei bevorzugt eine definierte Speisespannung für die Lasten 11, 12, wodurch Schalteigenschaften der Lasten 11, 12 unabhängig von der Höhe der an der Spannungsversorgung 16 anliegenden Potentiale 20, 21 sind.

Falls die gemeinsame Freilaufeinheit 15 als Feldeffekt-Transistor mit parasitärer integrierter Diode ausgeführt ist, wird durch das gegenphasige Ansteuern der Freilaufeinheit 15 und der Schalteinheit 14 die parasitäre integrierte Diode durch den in diesem Fall niederohmig ausgeführten Kanalwiderstand der Freilaufeinheit 15 überbrückt, was zu verringerten Schaltverlusten führt. Somit kann eine Wärmeentwicklung verringert werden.

Alle induktiven Lasten 11, 12 werden mit Hilfe der für alle induktiven Lasten 11, 12 gemeinsamen Schalteinheit 14 pulsweitenmoduliert und zentral über die gemeinsame Spannungsversorgung 16 mit der definierten Speisespannung versorgt. Je nach Funktionsanforderung an die induktiven Lasten 11, 12 wird eine feste oder variable Taktfrequenz für die Pulsweitenmodulation erzeugt. Über das Tastverhältnis kann die definierte Speisespannung beispielsweise abhängig von einer Versorgungsspannungshöhe und/oder Wicklungstemperatur der induktiven Lasten 11, 12 angepasst werden.

Über die Endstufen 17, 18 werden die induktiven Lasten 11, 12 selektiv bzw. individuell zugeschaltet bzw. abgeschaltet. Im zugeschalteten bzw. eingeschalteten Zustand der induktiven Lasten 11, 12 fließt ein sogenannter Freilaufstrom über die für alle induktiven Lasten 11, 12 gemeinsame, zentrale Freilaufeinheit 15. Im abgeschalteten bzw. ausgeschalteten Zustand der induktiven Lasten 11, 12 wird eine in den induktiven Lasten 11, 12 gespeicherte elektrische Energie an der entsprechenden Endstufe 17, 18, die jeweils über eine Schnelllöschfunktion bzw. eine integrierte Löscheinrichtung verfügen, schnell abgebaut, wodurch dann schnelle Abschaltzeiten der induktiven Lasten 11, 12 gewährleistet werden können. Diese Schnelllöschfunktion bzw. Löscheinrichtung ist bevorzugt durch eine integrierte oder externe Überspannungsschutzeinrichtung der individuellen Endstufe 17, 18 realisiert.

In einer Weiterbildung der Erfindung verfügt daher zumindest eine der individuellen Endstufen 17, 18, bevorzugt alle individuellen Endstufen 17, 18, über eine interne oder externe Überspannungsschutzeinrichtung, welche die an einem Drain-Anschluss der individuellen Endstufe 17,18 anliegende Spannung begrenzt.

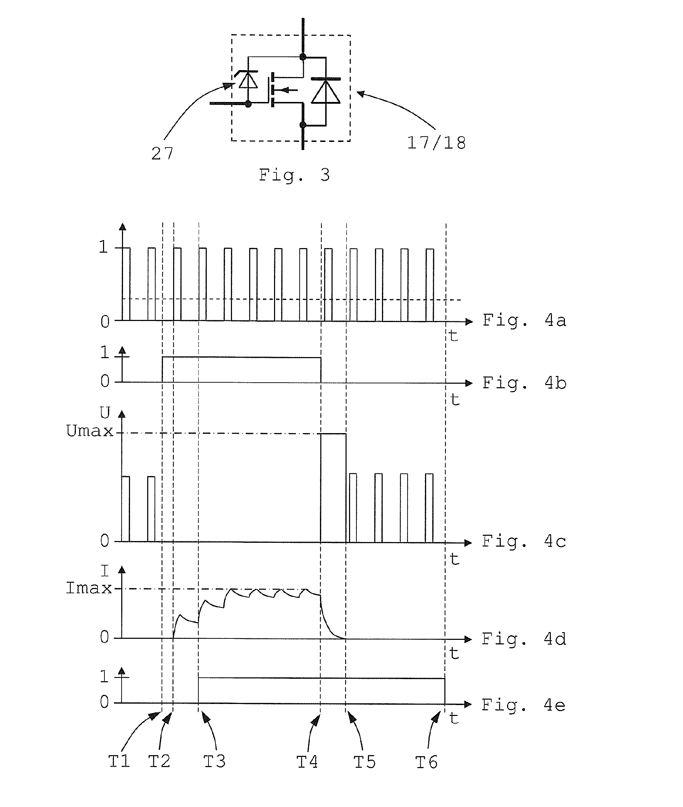

Eine individuelle Endstufe 17, 18 mit einer exemplarisch als integrierte Zener-Diode ausgebildeten Überspannungsschutzeinrichtung 27 ist in Fig. 3 dargestellt. Die Überspannungsschutzeinrichtung 27 bewirkt ein Abfließen der elektrischen Energie der induktiven Last 11, 12 sobald eine an dem Drain-Anschluss der individuellen Endstufe 17, 18 anliegende Spannung eine Durchbruchspannung der Überspannungsschutzeinrichtung 27 überschreitet, wodurch die dort anliegende Spannung begrenzt wird. Aus Fig. 3 geht ebenfalls hervor, dass zwischen dem Drain-Anschluss und dem Source-Anschluss der individuellen Endstufe 17, 18 eine weitere integrierte parasitäre Diode vorhanden sein kann.

Nach dem Abschalten der induktiven Last 11, 12 durch die jeweilige individuelle Endstufe 17, 18 bricht in der induktiven Last 11, 12 ein magnetisches Feld zusammen, wodurch es in der induktiven Last 11, 12 zu einer Spannungsinduktion kommt, welche einen Anstieg der Spannung an der jeweiligen individuellen Endstufe 17, 18 bewirkt. Sobald diese Spannung eine Durchbruchspannung der Überspannungsschutzeinrichtung 27 erreicht, verbindet die Überspannungsschutzeinrichtung 27 den Drain-Anschluss mit dem Gate-Anschluss dieser individuellen Endstufe 17, 18 elektrisch leitend, und die in der induktiven Last 11, 12 gespeicherte elektrische Energie fließt von dem Drain-Anschluss dieser individuellen Endstufe 17, 18 zu deren Source-Anschluss ab. Hierdurch kann zum einen eine Beschädigung der individuellen Endstufe 17,18 verhindert werden und zum anderen die in der induktiven Last 11, 12 gespeicherte elektrische Energie schnell abgebaut werden, was zu einer Verkürzung der Abschaltzeit der induktiven Last 11, 12 führt.

Die für alle induktiven Lasten 11, 12 gemeinsame Steuereinheit 13 ist vorzugsweise als Mikrocontroller ausgeführt und verfügt über eine Kommunikationsschnittstelle 26, um derselben Steuerbefehle zu übermitteln. Mit Hilfe der Steuereinheit 13 ist die pulsweitenmodulierte Schalteinheit 14, die Freilaufeinheit 15 sowie die Endstufen 17, 18 ansteuerbar.

Fig. 4a bis 4e zeigen exemplarisch zeitliche Verläufe der Schaltstellungen der gemeinsamen pulsweitenmodulierten Schalteinheit 14 und der individuellen Endstufen 17,18 der Ansteuerschaltung 10 aus Fig. 2, sowie eines Stroms und einer Spannung an der individuellen Endstufe 17. Die dargestellten Verläufe laufen zeitlich parallel ab, was durch die senkrechten Linien der Zeitpunkte T1 bis T6 angedeutet ist. Die Zeitachsen bilden somit in allen Figuren 4a bis 4e die waagrechten Achsen t.

Aus Fig. 4a geht ein zeitlicher Verlauf der Schaltstellungen (senkrechte Achse) der gemeinsamen Schalteinheit 14 hervor. Die Schaltstellung "1" bedeutet hierbei, dass die Schalteinheit 14 eine elektrisch leitende Verbindung zwischen deren Source- und Drain-Anschluss herstellt, das heißt eingeschaltet ist und die Schaltstellung "0" bedeutet, dass die Schalteinheit keine elektrisch leitende Verbindung zwischen deren Source- und Drain-Anschluss herstellt, das heißt ausgeschaltet ist. Die gemeinsame Freilaufeinheit 15 wird durch die Steuereinheit 13 gegenphasig zur Schalteinheit 14 geschaltet, somit nimmt die Freilaufeinheit 15 die Schaltstellung "1" ein, wenn die Schalteinheit 14 die Schaltstellung "0" annimmt, und sie nimmt die Schaltstellung "0" ein, wenn die Schalteinheit 14 die Schaltstellung "1" annimmt.

Wie Fig. 4a zeigt, wird die gemeinsame Schalteinheit 14 pulsweitenmoduliert an- bzw. ausgeschaltet. Dabei kann durch Anpassung des Tastverhältnisses der Pulsweitenmodulation (Dauer der Schaltstellung "1" im Verhältnis zur Gesamttaktlänge) an dem Source-Anschluss der Schalteinheit 14, bzw. an dem Drain-Anschluss der Freilaufeinheit 15 eine definierte Speisespannung für die induktiven Lasten 17, 18 bereitgestellt werden, welche weitestgehend unabhängig von einem Spannungsniveau der Spannungsversorgung 16 ist. Dies ist bei der Verwendung von Batterien zur Spannungsversorgung von Vorteil, da deren Betriebsspannung stark von einem Batterieladezustand abhängig ist. Dementsprechend wird das Tastverhältnis der Pulsweitenmodulation im laufenden Betrieb der Ansteuerschaltung 10 zur Aufrechterhaltung einer konstanten Speisespannung bevorzugt dynamisch an das Spannungsniveau der Spannungsversorgung 16 angepasst, was in Fig. 4a jedoch nicht gezeigt ist. Das Niveau der durch das dargestellte Tastverhältnis gebildeten definierten Speisespannung im Vergleich zum Spannungsniveau der Spannungsversorgung 16 verdeutlicht die Höhe der gestrichelten waagerechten Linie (Speisespannung) im Vergleich zu der Höhe des Wertes "1" (Spannungsniveau der Spannungsversorgung 16).

Fig. 4b stellt einen zeitlichen Verlauf der Schaltstellungen (senkrechte Achse) der individuellen Endstufe 17 dar. Zu einem Zeitpunkt T1 wird die individuelle Endstufe 17 durch die Steuereinheit 13 eingeschaltet, das heißt deren Schaltstellung wechselt von dem Wert "0" auf den Wert "1", wodurch eine leitende Verbindung zwischen dem Source- und dem Drain-Anschluss der individuellen Endstufe 17 hergestellt wird. Zu einem Zeitpunk T4 wird die individuelle Endstufe 17 durch die Steuereinheit 13 abgeschaltet, das heißt deren Schaltstellung wechselt von dem Wert "1" auf den Wert "0", wodurch die leitende Verbindung zwischen dem Source- und dem Drain-Anschluss der individuellen Endstufe 17 getrennt wird.

Die Fig. 4e zeigt einen zeitlichen Verlauf der Schaltstellungen der individuellen Endstufe 18, welche jedoch zu den Zeitpunkten T3 und T6 ein- beziehungsweise abgeschaltet wird. Das Ein- und Abschalten der individuellen Endstufen 17 und 18 erfolgt hierbei unabhängig voneinander und unabhängig von einem Schaltzustand der gemeinsamen Schalteinheit 14 oder der gemeinsamen Freilaufeinheit 15. Somit richtet sich der Schaltzustand der individuellen Endstufen 17, 18 ausschließlich nach dem Bedarf zur Aktivierung oder Deaktivierung der induktiven Last 11, 12.

Die Fig. 4c zeigt einen zeitlichen Verlauf einer zwischen dem Source- und dem Drain-Anschluss der individuellen Endstufe 17 anliegenden Spannung U (senkrechte Achse). Vor dem Zeitpunkt T1 ist die individuelle Endstufe 17 ausgeschaltet, somit entspricht der an der individuellen Endstufe 17 anliegende Potentialunterschied (anliegende Spannung) im Wesentlichen der durch die gemeinsame Schalteinheit 14 getakteten Betriebsspannung der Spannungsversorgung 16 (definierte Speisespannung). Zwischen den Zeitpunkten T1 und T4 ist die individuelle Endstufe 17 eingeschaltet, somit liegt kein nennenswerter Potentialunterschied zwischen dem Source- und dem Drain-Anschluss der individuellen Endstufe 17 an.

Zum Zeitpunkt T4 wird die individuelle Endstufe 17 abgeschaltet, wodurch es zu einem Zusammenbrechen eines Magnetfeldes in der induktiven Last 11 kommt. Dieses Zusammenbrechen bewirkt wiederum eine Spannungsinduktion in der induktiven Last 11, welche einen starken Spannungsanstieg an der abgeschalteten individuellen Endstufe 17 hervorruft.

Eine Überspannungsschutzeinrichtung, beispielsweise die Überspannungsschutzeinrichtung 27 aus Fig. 3, verbindet im Falle eines Spannungsanstiegs an der individuellen Endstufe 17 über eine Durchbruchspannung Umax der Überspannungsschutzeinrichtung den Drain-Anschluss und den Gate-Anschluss der individuellen Endstufe 17 elektrisch leitend. Somit kann die in der induktiven Last 11 gespeicherte elektrische Energie innerhalb kurzer Zeit über den Source-Anschluss der individuellen Endstufe 17 abfließen, was zum Zeitpunkt T5 weitestgehend abgeschlossen ist. Die Überspannungsschutzeinrichtung trennt dann die elektrisch leitende Verbindung zwischen dem Drain- und dem Gate-Anschluss der individuellen Endstufe 17. Danach entspricht der an der individuellen Endstufe 17 anliegende Potentialunterschied wieder im Wesentlichen der mittels der Schalteinheit 14 getakteten Betriebsspannung der Spannungsversorgung 16 (definierte Speisespannung).

Die Fig. 4d zeigt einen zeitlichen Verlauf eines durch den Drain-Anschluss der individuellen Endstufe 17 fließenden Stroms I (senkrechte Achse). Vor dem Zeitpunkt T1 ist die individuelle Endstufe 17 ausgeschaltet. Zum Zeitpunkt T1 wird die induktive Last 11 über die individuelle Endstufe 17 eingeschaltet. Wie aus Fig. 4a hervorgeht, ist zu diesem Zeitpunkt T1 die gemeinsame Schalteinheit 14 jedoch ausgeschaltet, weshalb bis zum Zeitpunkt T2 noch kein Strom durch die induktive Last 11 und die individuelle Endstufe 17 fließt. Während der dem Zeitpunkt T2 nachfolgenden Taktzyklen der Schalteinheit 14 erreicht der durch die individuelle Endstufe 17 fließende Strom einen maximalen Wert Imax der bis zum Abschalten der individuellen Endstufe 17 zum Zeitpunkt T4 weitestgehend gehalten wird. Das zyklische Ansteigen und Abfallen des Stroms zwischen T2 und T4 ist dabei durch das taktgebundene An- und Abschalten der gemeinsamen Schalteinheit 14 und Freilaufeinheit 15 bedingt.

Zum Zeitpunkt T4 wird die individuelle Endstufe 17 wieder abgeschaltet, was in der induktiven Last 11 zum Zusammenbrechen des magnetischen Feldes und der damit einhergehenden Spannungsinduktion führt. Infolgedessen löst zum Zeitpunkt T4 die Überspannungsschutzeinrichtung aus, woraufhin der durch den Drain-Anschluss der individuellen Endstufe 17 fließende Strom bis zum Zeitpunkt T5 stark abfällt. Nach dem Zeitpunkt T5 ist die in der induktiven Last 11 gespeicherte Energie abgebaut und die individuelle Endstufe 17 abgeschaltet, wodurch kein weiterer Stromfluss messbar ist.

### Bezugszeichen

- 1: Ansteuerschaltung
- 2: induktive Last
- 3: Schalteinheit
- 4: Schalteinheit
- 5: Freilaufeinheit
- 6: Spannungsversorgung
- 7: Potential
- 8: Potential

- 10: Ansteuerschaltung
- 11: induktive Last
- 12: induktive Last
- 13: Steuereinheit
- 14: Schalteinheit
- 15: Freilaufeinheit
- 16: Spannungsversorgung
- 17: Endstufe
- 18: Endstufe
- 19: Widerstand
- 20: Potential
- 21: Potential
- 22: Widerstand
- 23: Widerstand
- 24: Widerstand
- 25: Kapazität
- 26: Kommunikationsschnittstelle
- 27: Überspannungsschutzeinrichtung
- T1 - T6: Zeitpunkt

## Patentansprüche

1. Ansteuerschaltung für mehrere induktive Lasten,
• mit einer für alle induktiven Lasten (11, 12) gemeinsamen Steuereinheit (13),
• mit einer für alle induktiven Lasten (11, 12) gemeinsamen pulsweitenmodulierten Schalteinheit (14),
• mit einer für alle induktiven Lasten (11, 12) gemeinsamen Freilaufeinheit (15), welche als eine pulsweitenmodulierte zweite Schalteinheit ausgebildet ist,
• mit einer für alle induktiven Lasten (11, 12) gemeinsamen Spannungsversorgung (16), und
• mit einer für jede induktive Last (11, 12) individuellen Endstufe (17, 18), wobei die gemeinsame pulsweitenmodulierte Schalteinheit (14) und die individuellen Endstufen (17, 18) derart mit der gemeinsamen Steuereinheit (13), der gemeinsamen Freilaufeinheit (15) und der gemeinsamen Spannungsversorgung (16) verschaltet sind, dass
• einerseits die gemeinsame pulsweitenmodulierte Schalteinheit (14) und die gemeinsame Freilaufeinheit (15) in Reihe geschaltet und
• andererseits die Endstufen (17, 18) zusammen mit den in Reihe zu den Endstufen (17, 18) geschalteten induktiven Lasten (11, 12) parallel zu der gemeinsamen Freilaufeinheit (15) geschaltet sind,
wobei die gemeinsame pulsweitenmodulierte Schalteinheit (14), gesteuert durch die gemeinsame Steuereinheit (13), die induktiven Lasten (11, 12) über die gemeinsame Spannungsversorgung zentral und pulsweitenmoduliert mit Spannung versorgt und die gemeinsame Freilaufeinheit (15) durch die gemeinsame Steuereinheit (13) im Betrieb der Ansteuerschaltung stets gegenphasig zu der gemeinsamen pulsweitenmodulierten Schalteinheit (14) angesteuert ist, und
wobei die Endstufen (17, 18) gesteuert durch die gemeinsame Steuereinheit (13) jede der induktiven Lasten (11, 12) entweder individuell zuschaltet oder abschaltet.

2. Ansteuerschaltung nach Anspruch 1, **dadurch gekennzeichnet, dass** die gemeinsame pulsweitenmodulierte Schalteinheit (14) oder die gemeinsame Freilaufeinheit (15) als Halbleiterschalter oder Halbleiterschalter mit integrierter Diode ausgebildet ist.

3. Ansteuerschaltung nach Anspruch 2, **dadurch gekennzeichnet, dass** die gemeinsame pulsweitenmodulierte Schalteinheit (14) oder die gemeinsame Freilaufeinheit (15) als Bipolar-Transistor oder als Feldeffekt-Transistor ausgebildet ist.

4. Ansteuerschaltung nach einem der Ansprüche 1 bis 3, **dadurch gekennzeichnet, dass** die gemeinsame Freilaufeirtheit (15) als Transistor mit integrierter parasitärer Diode ausgebildet ist.

5. Ansteuerschaltung nach einem der Ansprüche 1 bis 4, **dadurch gekennzeichnet, dass** die individuellen Endstufen (17, 18) der induktiven Lasten (11, 12) als Transistoren ausgebildet sind.

6. Ansteuerschaltung nach Anspruch 5, **dadurch gekennzeichnet, dass** die individuellen Endstufen (17, 18) der induktiven Lasten (11, 12) als Bipolar-Transistoren jeweils mit externer Überspannungsschutzeinrichtung, ausgebildet sind.

7. Ansteuerschaltung nach Anspruch 5, **dadurch gekennzeichnet, dass** die individuellen Endstufen (17, 18) der induktiven Lasten (11, 12) als Feldeffekt-Transistoren jeweils mit integrierter Überspannungsschutzeinrichtung ausgebildet sind.

8. Ansteuerschaltung nach einem der Ansprüche 1 bis 7, **dadurch gekennzeichnet, dass** die als Transistor ausgebildete, pulsweitenmodulierte Schalteinheit (14) über einen Gate-Anschluss an die gemeinsame Steuereinheit (13), über einen Drain-Anschluss an ein erstes Potential (20) der gemeinsamen Spannungsversorgung (16) und über einen Source-Anschluss an die gemeinsame Freilaufeinheit (15) angeschlossen ist, die ihrerseits an ein zweites Potential (21) der gemeinsamen Spannungsversorgung (16) angeschlossen ist.

9. Ansteuerschaltung nach Anspruch 8, **dadurch gekennzeichnet, dass** die Freilaufeinheit (15) als Transistor ausgebildet ist, wobei der Source-Anschluss der als Transistor ausgebildeten Schalteinheit (14) an einen Drain-Anschluss der als Transistor ausgebildeten Freilaufeinheit (15) angeschlossen ist, und wobei die Freilaufeinheit (15) über einen Gate-Anschluss an die gemeinsame Steuereinheit (13) und über einen Source-Anschluss an das zweite Potential (21) der gemeinsamen Spannungsversorgung (16) angeschlossen ist.

10. Ansteuerschaltung nach einem der Ansprüche 1 bis 9, **dadurch gekennzeichnet, dass** die als Transistoren ausgebildeten Endstufen (17, 18) jeweils über einen Gate-Anschluss an die gemeinsame Steuereinheit (13), über einen Drain-Anschluss an die jeweilige induktive Last (11, 12) und über einen Source-Anschluss an die gemeinsame Spannungsversorgung (16) angeschlossen sind.

11. Ansteuerschaltung nach Anspruch 10, **dadurch gekennzeichnet, dass** zumindest eine der individuellen Endstufen (17, 18), bevorzugt alle individuellen Endstufen (17, 18), über eine interne oder externe Überspannungsschutzeinrichtung (27) verfügt, welche eine an einem Drain-Anschluss der individuellen Endstufe (17, 18) anliegende Spannung begrenzt.

12. Verwendung der Ansteuerschaltung nach einem der Ansprüche 1 bis 11 in einem Getriebe zur Ansteuerung von elektromechanisch betätigten Schaltelementen des Getriebes, insbesondere in einem elektronischen Steuergerät eines automatisierten oder automatischen Personen- oder Nutzfahrzeuggetriebes zur Ansteuerung von elektromechanischen Hydraulik- oder Pneumatikventilen für die Ansteuerung von Schaltelementen des Personen- oder Nutzfahrzeuggetriebes.

13. Verfahren zur Ansteuerung von induktiven Lasten (11, 12) mit einer Ansteuerschaltung nach einem der Ansprüche 1 bis 11, **dadurch gekennzeichnet, dass** die Schalteinheit (14) und die gemeinsame Freilaufeinheit (15) gegenphasig zur Erzeugung einer definierten Speisespannung der induktiven Lasten (11, 12) pulsweitenmoduliert durch die gemeinsame Steuereinheit (13) angesteuert werden und dass die individuellen Endstufen (17, 18) angesteuert durch die gemeinsame Steuereinheit (13) die induktiven Lasten (11, 12) individuell zu- oder abschaltet, unabhängig von einem Schaltzustand der Schalteinheit (14) oder der gemeinsamen Freilaufeinheit (15).

14. Verfahren nach Anspruch 13 mit einer Ansteuerschaltung nach Anspruch 11, **dadurch gekennzeichnet, dass** nach einem Abschalten einer der induktiven Lasten (11, 12) durch die jeweilige individuelle Endstufe (17, 18) eine Spannung an dieser individuellen Endstufe (17, 18) ansteigt und dass sobald diese Spannung eine Durchbruchspannung der Überspannungsschutzeinrichtung (27) erreicht, die Überspannungsschutzeinrichtung (27) den Drain-Anschluss mit dem Gate-Anschluss dieser individuellen Endstufe (17, 18) elektrisch leitend verbindet, und eine in der induktiven Last gespeicherte elektrische Energie von dem Drain-Anschluss dieser individuellen Endstufe (17, 18) zu deren Source-Anschluss abfließt.

## Claims

1. Driver circuit for a plurality of inductive loads,
- having a control unit (13) which is common to all of the inductive loads (11, 12),
- having a pulse-width-modulated switching unit (14) which is common to all of the inductive loads (11, 12),
- having a freewheeling unit (15) which is common to all of the inductive loads (11, 12) and is designed as a second pulse-width-modulated switching unit,
- having a voltage supply (16) which is common to all of the inductive loads (11, 12), and
- having an individual end stage (17, 18) for each inductive load (11, 12), wherein the common pulse-width-modulated switching unit (14) and the individual end stages (17, 18) are connected to the common control unit (13), the common freewheeling unit (15) and the common voltage supply (16) such that
- the common pulse-width-modulated switching unit (14) and the common freewheeling unit (15) are connected in series and
- the end stages (17, 18) together with the inductive loads (11, 12) which are connected in series with the end stages (17, 18) are connected in parallel with the common freewheeling unit (15),
wherein the common pulse-width-modulated switching unit (14), controlled by the common control unit (13), supplies the inductive loads (11, 12) with a voltage in a central and pulse-width-modulated manner via the common voltage supply and the common freewheeling unit (15) is driven by the common control unit (13) during operation of the driver circuit in a manner which is always 180 degrees out of phase with the common pulse-width-modulated switching unit (14), and wherein the end stages (17, 18), controlled by the common control unit (13), either individually connect or disconnect each of the inductive loads (11, 12).

2. Driver circuit according to Claim 1, **characterized in that** the common pulse-width-modulated switching unit (14) or the common freewheeling unit (15) is designed as semiconductor switch or semiconductor switch with integrated diode.

3. Driver circuit according to Claim 2, **characterized in that** the common pulse-width-modulated switching unit (14) or the common freewheeling unit (15) is designed as bipolar transistor or as field-effect transistor.

4. Driver circuit according to any of Claims 1 to 3, **characterized in that** the common freewheeling unit (15) is designed as transistor with integrated parasitic diode.

5. Driver circuit according to any of Claims 1 to 4, **characterized in that** the individual end stages (17, 18) of the inductive loads (11, 12) are designed as transistors.

6. Driver circuit according to Claim 5, **characterized in that** the individual end stages (17, 18) of the inductive loads (11, 12) are designed as bipolar transistors each with an external surge protection device.

7. Driver circuit according to Claim 5, **characterized in that** the individual end stages (17, 18) of the inductive loads (11, 12) are designed as field-effect transistors each with an integrated surge protection device.

8. Driver circuit according to any of Claims 1 to 7, **characterized in that** the pulse-width-modulated switching unit (14) which is designed as transistor is connected via a gate connection to the common control unit (13), via a drain connection to a first potential (20) of the common voltage supply (16) and via a source connection to the common freewheeling unit (15), which common freewheeling unit, for its part, is connected to a second potential (21) of the common voltage supply (16).

9. Driver circuit according to Claim 8, **characterized in that** the freewheeling unit (15) is designed as transistor, wherein the source connection of the switching unit (14) designed as transistor is connected to a drain connection of the freewheeling unit (15) designed as transistor, and wherein the freewheeling unit (15) is connected via a gate connection to the common control unit (13) and via a source connection to the second potential (21) of the common voltage supply (16).

10. Driver circuit according to any of Claims 1 to 9, **characterized in that** the end stages (17, 18) designed as transistors are each connected via a gate connection to the common control unit (13), via a drain connection to the respective inductive load (11, 12) and via a source connection to the common voltage supply (16).

11. Driver circuit according to Claim 10, **characterized in that** at least one of the individual end stages (17, 18), preferably all of the individual end stages (17, 18), has (have) an internal or external surge protection device (27) which limits a voltage present at a drain connection of the individual end stage (17, 18).

12. Use of the driver circuit according to any of Claims 1 to 11 in a gearbox for driving electromechanically actuated switching elements in the gearbox, in particular in an electronically controlled gearbox of an automated or automatic passenger or utility vehicle for driving electromechanical hydraulic or pneumatic valves for driving switching elements of the passenger- or utility-vehicle gearbox.

13. Method for driving inductive loads (11, 12) with a driver circuit according to any of Claims 1 to 11, **characterized in that** the switching unit (14) and the common freewheeling unit (15) are driven by the common control unit (13) 180 degrees out of phase to generate a defined feed voltage of the inductive loads (11, 12) in a pulse-width-modulated manner and **in that** the individual end stages (17, 18), driven by the common control unit (13), individually connect or disconnect the inductive loads (11, 12), independently of a switching state of the switching unit (14) or of the common freewheeling unit (15).

14. Method according to Claim 13 having a driver circuit according to Claim 11, **characterized in that**, once one of the inductive loads (11, 12) has been disconnected by the respective individual end stage (17, 18), a voltage at said individual end stage (17, 18) increases and **in that** as soon as said voltage reaches a breakdown voltage of the surge protection device (27), the surge protection device (27) electrically conductively connects the drain connection to the gate connection of said individual end stage (17, 18) and electrical energy stored in the inductive load flows away from the drain connection of said individual end stage (17, 18) to the source connection thereof.

## Revendications

1. Circuit de commande de plusieurs charges inductives,
présentant
une unité de commande (13) commune à toutes les charges inductives (11, 12),
une unité de commutation (14) à modulation de la largeur des impulsions commune à toutes les charges inductives (11, 12),
une unité de fonctionnement en roue libre (15) commune à toutes les charges inductives (11, 12) et configurée comme deuxième unité de commutation à modulation de la largeur d'impulsions,
une alimentation (16) en tension commune à toutes les charges inductives (11, 12) et
un étage final (17, 18) pour chaque charge inductive (11, 12),
l'unité commune (14) de commutation à modulation de la largeur des impulsions et les étages finaux individuels (17, 18) étant raccordés à l'unité commune de commande (13), à l'unité commune de fonctionnement en roue libre (15) et à l'alimentation commune (16) en tension de telle sorte que
d'une part, l'unité commune (14) de commutation à modulation de la largeur d'impulsions et l'unité commune (15) de fonctionnement en roue libre soient raccordés en série et
d'autre part, les étages finaux (17, 18) et les charges inductives (11, 12) raccordées en série sur les étages finaux (17, 18) soient raccordés en parallèle à l'unité commune (15) de fonctionnement en roue libre,
l'unité commune (14) de commutation à modulation de la largeur d'impulsions commandée par l'unité commune de commande (13) module centralement la largeur des impulsions des charges inductives (11, 12) par l'intermédiaire de l'alimentation commune en tension et les alimente en tension,
l'unité commune (15) de fonctionnement en roue libre étant toujours commandée par l'unité commune de commande (13) en opposition de phase à l'unité commune (14) de commutation à modulation de la largeur d'impulsions lorsque le circuit de commande est en fonctionnement et
les étages finaux (17, 18) branchent et débranchent chacune des charges inductives (11, 12) sous la commande de l'unité commune (13) de commande.

2. Circuit de commande selon la revendication 1, **caractérisé en ce que** l'unité commune (14) de commutation à modulation de la largeur d'impulsions ou l'unité commune (15) de fonctionnement en roue libre sont configurées comme commutateurs semi-conducteurs ou commutateurs semi-conducteurs à diode intégrée.

3. Circuit de commande selon la revendication 2, **caractérisé en ce que** l'unité commune (14) de commutation à modulation de la largeur d'impulsions ou l'unité commune (15) de fonctionnement en roue libre sont configurées comme transistors bipolaires ou comme transistors à effet de champ.

4. Circuit de commande selon l'une des revendications 1 à 3, **caractérisé en ce que** l'unité commune (15) de fonctionnement en roue libre est configurée comme transistor à diode parasite intégrée.

5. Circuit de commande selon l'une des revendications 1 à 4, **caractérisé en ce que** les étages finaux (17, 18) des différentes charges inductives (11, 12) sont configurés comme transistors.

6. Circuit de commande selon la revendication 5, **caractérisé en ce que** les étages finaux (17, 18) des différentes charges inductives (11, 12) sont configurés comme transistors bipolaires, chacun avec un dispositif externe de protection contre les surtensions.

7. Circuit de commande selon la revendication 5, **caractérisé en ce que** les étages finaux (17, 18) des différentes charges inductives (11, 12) sont configurés comme transistors à effet de champ, chacun avec un dispositif intégré de protection contre les surtensions.

8. Circuit de commande selon l'une des revendications 1 à 7, **caractérisé en ce que** l'unité (14) de commutation à modulation de la largeur d'impulsions configurée comme transistor est raccordée par une borne de grille à l'unité commune de commande (13), par une borne de drain à un premier potentiel (20) de l'alimentation commune en tension (16) et par une borne de source à l'unité commune (15) de fonctionnement en roue libre, cette dernière étant raccordée à un deuxième potentiel (21) de l'alimentation commune en tension (16).

9. Circuit de commande selon la revendication 8, **caractérisé en ce que** l'unité (15) de fonctionnement en roue libre est configurée comme transistor, la borne de source de l'unité de commutation (14) configurée comme transistor étant raccordée à la borne de drain de l'unité (15) de fonctionnement en roue libre configurée comme transistor, l'unité (15) de fonctionnement en roue libre étant raccordée par une borne de grille à l'unité commune de commande (13) et par une borne de source au deuxième potentiel (21) de l'alimentation commune en tension (16).

10. Circuit de commande selon l'une des revendications 1 à 9, **caractérisé en ce que** les étages finaux (17, 18) configurés comme transistor sont chacun raccordé par une borne de grille à l'unité commune de commande (13), par une borne de drain à la charge inductive respective (11, 12) et par une borne de source à l'alimentation commune en tension (16).

11. Circuit de commande selon la revendication 10, **caractérisé en ce que** des étages finaux (17, 18) et de préférence tous les étages finaux (17, 18) disposent d'un dispositif interne ou externe (27) de protection contre les surtensions qui limite la tension appliquée sur la borne de drain de chaque étage final (17, 18).

12. Utilisation du circuit de commande selon l'une des revendications 1 à 11 dans une transmission pour la commande par des moyens électromécaniques et en particulier dans un appareil électronique de commande de la transmission automatisée ou automatique d'une voiture ou d'un véhicule utilitaire, pour la commande de soupapes hydrauliques ou pneumatiques électromécaniques qui commandent les éléments de changement de rapport de la transmission de la voiture ou du véhicule utilitaire.

13. Procédé de commande de charges inductives (11, 12) par un circuit de commande selon l'une des revendications 1 à 11, **caractérisé en ce que** l'unité de commutation (14) et l'unité commune (15) de fonctionnement en roue libre sont modulées en largeur d'impulsions et en opposition de phase pour former une tension d'alimentation définie des charges inductives (11, 12) par l'unité commune de commande (13) et **en ce que** les différents étages finaux (17, 18) sont commandés par l'unité commune de commande (13) pour brancher ou débrancher les charges inductives (11, 12) individuellement en fonction de l'état de commutation de l'unité de commutation (14) ou de l'unité commune (15) de fonctionnement en roue libre.

14. Procédé selon la revendication 13, avec un circuit de commande selon la revendication 11, **caractérisé en ce qu'**après le branchement d'une des charges inductives (11, 12) par l'étage final respectif (17, 18), la tension appliquée sur cet étage final (17, 18) monte et **en ce que** dès que cette tension atteint une tension de claquage du dispositif (27) de protection contre les surtensions, le dispositif (27) de protection contre les surtensions raccorde de manière électriquement conductrice la borne de drain à la borne de grille de cet étage final (17, 18), l'énergie électrique accumulée dans la charge inductive s'écoulant depuis la borne de drain de cet étage final (17, 18) vers sa borne de source.
